# EUROPÄISCHE PATENTSCHRIFT

(11) **EP 0 887 926 B1**
(45) Veröffentlichungstag und Bekanntmachung des Hinweises auf die Patenterteilung: **28.04.2004**
(21) Anmeldenummer: 98103339.2
(22) Anmeldetag: 26.02.1998
(51) Int. Cl.: H03H 7/25, H03G 1/00

(54) **Stromquelle für ein Pin-Dioden Dämpfungsglied**
Current source for a PIN-diode attenuator
Source de courant pour un atténuateur à diodes PIN

(30) Priorität: 29.06.1997 DE 19725993
(43) Veröffentlichungstag der Anmeldung: 30.12.1998
(73) Patentinhaber: Marconi Communications GmbH, 71522 Backnang (DE)
(72) Erfinder: Mück, Karl, 71650 Sulzbach An Der Murr (DE)
(74) Vertreter: Heuer, Wilhelm, Dr.

(56) Entgegenhaltungen:
- FR-A- 2 566 205
- US-A- 3 529 266

## Beschreibung

Die vorliegende Erfindung betrifft eine spannungsgesteuerte Stromquelle zum Erzeugen eines Steuerstroms für ein PIN-Dioden-Dämpfungsglied.

Eine derartige spannungsgesteuerte Stromquelle ist aus U. Tietze, Ch. Schenk, Halbleiter-Schaltungstechnik, 10. Auflage, 1993, Springer-Verlag, Seite 369-371 bekannt. Mit spannungsgesteuerten Stromquellen kann man einem Verbraucher, hier einem PIN-Dioden Dämpfungsglied, einen Strom einprägen, der von der Last am Ausgang der Stromquelle unabhängig ist und nur von der Eingangsspannung der Stromquelle bestimmt wird.

Die Kennlinie eines PIN-Dioden Dämpfungsgliedes ist normalerweise nicht linear und hat einen von der Temperatur abhängigen Verlauf. Aufgabe der Erfindung ist es, eine Stromquelle für ein PIN-Dioden Dämpfungsglied anzugeben, die dessen Kennlinie linearisiert und außerdem temperaturkompensiert.

### Vorteile der Erfindung

Die genannte Aufgabe wird mit den Merkmalen des Patentanspruchs 1 dadurch gelöst, daß zu einem Ausgangswiderstand der Stromquelle ein oder mehrere Widerstände in Reihe geschaltet sind und daß zu jedem dieser zusätzlichen in Reihe geschalteten Widerstände eine Diode parallel geschaltet ist. Durch diese Beschaltung der spannungsgesteuerten Stromquelle kann der ansonsten lineare Zusammenhang zwischen der Eingangsspannung der Stromquelle und dessen Ausgangsstrom so verzerrt werden, daß der als Steuerstrom für das Dämpfungsglied dienende Ausgangsstrom der Stromquelle einen nichtlinearen Verlauf der Dämpfungskennlinie kompensiert.

Gemäß einem Unteranspruch hängt es von der Größe der zum Ausgangswiderstand der Stromquelle zusätzlich in Reihe geschalteten Widerstände ab, welchen Verlauf der Ausgangsstrom in Abhängigkeit von der Eingangsspannung der Stromquelle annimmt.

### Beschreibung eines Ausführungbeispiels

Anhand eines in der Zeichnung dargestellten Ausführungsbeispiels wird nachfolgend die Erfindung näher erläutert.

Es zeigen:
Figur 1 ein Schaltbild eines mit einer spannungsgesteuerten Stromquelle beschalteten PIN-Dioden Dämpfungsgliedes,
Figur 2 mehrere Dämpfungsverläufe und
Figur 3 mehrere Verläufe des Ausgangsstroms der Stromquelle in Abhängigkeit von der Eingangsspannung.

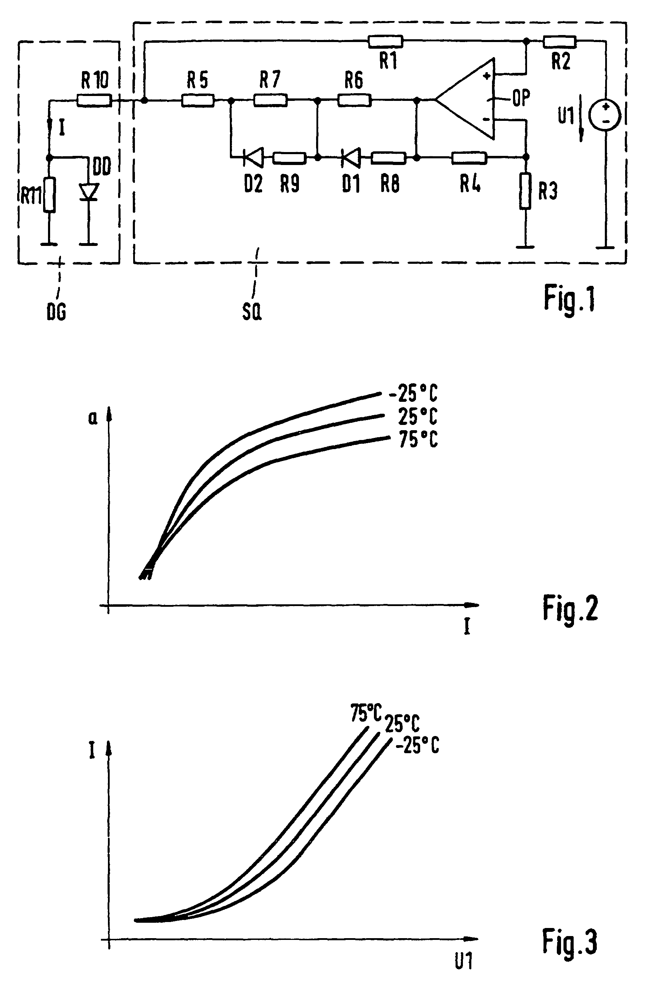

In der Figur 1 ist das Schaltbild eines PIN-Dioden Dämpfungsgliedes DG und einer den Steuerstrom I für das Dämpfungsglied DG erzeugenden spannungsgesteuerten Stromquelle SQ dargestellt. Das Dämpfungsglied DG besteht aus einem Eingangswiderstand R10 und einem zu diesem in Reihe geschalteten weiteren Widerstand R11, dem eine PIN-Diode DD parallel geschaltet ist. In dem gezeigten Ausführungsbeispiel enthält das Dämpfungsglied DG nur eine PIN-Diode DD. Das Dämpfungsglied DG kann aber auch mit mehreren PIN-Dioden DD beschaltet sein, was davon abhängt, welcher Dämpfungsverlauf in Abhängigkeit von einer Steuerspannung I realisiert werden soll.

In der Figur 2 sind mehrere Kennlinien eingezeichnet, die qualitativ die Abhängigkeit der Dämpfung a vom Steuerstrom I zeigen. Es ist festzustellen, daß der Zusammenhang zwischen der Dämpfung a und dem Steuerstrom I nicht linear ist. Außerdem ist die Dämpfungskennlinie temperaturabhängig. Wie die drei Kennlinienverläufe für die Temperaturen -25° C, +25° C und +75° C in Figur 2 zeigen, ändert sich die Kennliniensteilheit mit der Temperatur.

Es ist wünschenswert, eine Dämpfungskennlinie zu erzielen, die einerseits einen linearen und andererseits einen temperaturunabhängigen Verlauf aufweist.

Der Steuerstrom I für das Dämpfungsglied DG wird von einer spannungsgesteuerten Stromquelle SQ geliefert. Eine spannungsgesteuerte Stromquelle hat die Eigenschaft, daß sie einer Last einen Strom I einprägt, der nur von einer Eingangsspannung U1 der Stromquelle SQ bestimmt wird. Eine spannungsgesteuerte Stromquelle mit linearer Abhängigkeit zwischen ihrem Ausgangsstrom I und ihrer Eingangsspannung U1 ist in O. Tietze, Ch. Schenk, Halbleiterschaltungstechnik, 10. Auflage, Springer-Verlag, 1993, Seite 369-371 beschrieben. Wie diese bekannte spannungsgesteuerte Stromquelle weist die spannungsgesteuerte Stromquelle SQ in Fig. 1 einen Operationsverstärker OP auf, an dessen beiden Eingängen über Widerstände R2 und R3 die Eingangsspannung U1 anliegt. Am Ausgang ist der Operationsverstärker OP mit einem Ausgangswiderstand R5 beschaltet. Vom Ausgang des Ausgangswiderstandes R5 führt eine Rückkopplungsschleife mit einem Widerstand R1 auf den positiven Eingang des Operationsverstärkers zurück. Ebenfalls ist der Ausgang des Operationsverstärkers über einen Widerstand R4 auf den negativen Eingang zurückgekoppelt.

Die spannungsgesteuerte Stromquelle SQ aus Fig. 1 unterscheidet sich von der bekannten spannungsgesteuerten Stromquelle dadurch, dass ihr Ausgangsstrom I, welcher der Steuerstrom für das Dämpfungsglied DG ist, nicht mehr linear abhängig ist von der Eingangsspannung U1 der Stromquelle SQ. Der Verlauf des Ausgangsstromes I in Abhängigkeit von der Eingangsspannung U1, wie in Figur 3 dargestellt, soll nicht linear und auch temperaturabhängig sein. Die Nichtlinearität und Temperaturabhängigkeit des Ausgangsstromes I soll so gestaltet sein, daß sie invers zu der Nichtlinearität und Temperaturabhängigkeit des Dämpfungsverlaufes a sind. Dadurch wird die Nichtlinearität und Temperaturabhängigkeit der Dämpfungskennlinie kompensiert.

Um die besagte Nichtlinearität und Temperaturabhängigkeit des Ausgangsstromes I der Stromquelle SQ zu erreichen, sind zu dem Ausgangswiderstand R5 in dem dargestellten Ausführungsbeispiel zwei weitere Widerstände R6 und R7 in Reihe geschaltet. Außerdem ist zu jedem dieser beiden Widerstände R6 und R7 eine Diode D1 und D2 parallel geschaltet. Bei einer kleinen Eingangsspannung U1 fließt nur ein kleiner Strom durch die Widerstände R6, R7 und R5.

Steigt die Eingangsspannung U1 weiter an, so wird der Spannungsabfall am Widerstand R6 solange ansteigen, bis die Diode D1 in den Durchlaßbereich kommt. Da der differenzielle Widerstand der Diode D1 im Durchlaßbereich erheblich kleiner ist als der Widerstand R6, kommt es zu einem überproportionalen Anstieg des Stromes I. Der Strom durch den Widerstand R6 und der Strom durch die Diode D1 fliessen nun über die Widerstände R7 und R5. Bei einem weiteren Anstieg der Eingangsspannung U1 wird der Spannungsabfall am Widerstand R7 so groß, daß auch die Diode D2 den Durchlaßbereich erreicht. Dadurch kommt es zu einem erneuten überproportionalen Anstieg des Stromes I. Der Strom I zeigt deshalb das in der Figur 3 dargestellte nichtlineare Verhalten.

Dadurch, daß die Spannungsschwelle für den Übergang vom Sperrbereich in den Durchlaßbereich der Dioden D1 und D2 temperaturabhängig ist, ergibt sich für den Ausgangsstrom I ein in der Figur 3 qualitativ dargestelltes temperaturabhängiges Verhalten.

Die Nichtlinearität und Temperaturabhängigkeit der Kennlinie des Ausgangsstromes I hängt schließlich von der Größe der Widerstände R6 und R7 und auch von den Durchlaßspannungen der Dioden D1 und D2 ab.
Die Bauteile müssen also so gewählt werden, daß der Steuerstrom I für das Dämpfungsglied DG in Abhängigkeit von der Eingangsspannung U1 einen solchen nichtlinearen und temperaturabhängigen Verlauf aufweist, daß es zu einer gewünschten Kompensation der Nichtlinearität und Temperaturabhängigkeit des Dämpfungsverlaufes a kommt.

Anstatt, wie im Ausführungsbeispiel in Figur 1 dargestellt ist, zwei Widerstände R6 und R7 mit parallel geschalteten Dioden D1 und D2 vorzusehen, können auch nur ein Widerstand oder mehr als zwei Widerstände mit parallel geschalteten Dioden zum Ausgangswiderstand R5 in Reihe geschaltet werden. Die Zahl der Widerstände und Dioden hängt letztendlich davon ab, welcher Verlauf für den Ausgangsstrom I in Abhängigkeit von der Eingangsspannung U1 realisiert werden soll.

Anstelle von Dioden D1, D2, können auch Transistoren, die vorzugsweise invers betrieben werden, zu den Widerständen R6, R7 parallel geschaltet werden.

Zu den Dioden D1 und D2 können noch Widerstände R8 und R9 in Reihe geschaltet werden. Mit diesen Widerständen ist ein Feinabgleich des Verlaufs der Dämpfungskennlinie möglich.

Mit der beschriebenen Stromquelle kann auch eine Temperaturkompensation anderer Schaltungskomponenten (z.B. Verstärker, Mischer) vorgenommen werden. Dazu wird in den negativen Eingang des Operationsverstärkers OP ein entsprechend temperaturabhängiger Strom eingeprägt. Das führt dann zu einer Parallelverschiebung der linearisierten Dämpfungskennlinie.

## Patentansprüche

1. Spannungsgesteuerte Stromquelle (SQ) für ein PIN-Dioden-Dämpfungsglied (DG), **dadurch gekennzeichnet, dass** zu einem Ausgangswiderstand (R5) der Stromquelle (SQ) ein oder mehrere Widerstände (R6, R7) in Reihe geschaltet sind, und dass zu jedem dieser zusätzlichen in Reihe geschalteten Widerstände (R6, R7) eine Diode (D1, D2) parallel geschaltet ist.

2. Stromquelle nach Anspruch 1, **dadurch gekennzeichnet, dass** der oder die zum Ausgangswiderstand (R5) der Stromquelle (SQ) in Reihe geschalteten Widerstände (R6, R7) so groß gewählt sind, dass der Steuerstrom (I) in Abhängigkeit von einer Eingangsspannung (U1) der spannungsgesteuerten Stromquelle (SQ) einen solchen nichtlinearen Verlauf annimmt, dass dadurch eine Nichtlinearität der Kennlinie des Dämpfungsgliedes (DG) kompensiert wird.

3. Stromquelle nach Anspruch 1, **dadurch gekennzeichnet, dass** zu jeder parallel geschalteten Diode (D1, D2) ein Widerstand (R8, R9) in Reihe geschaltet ist.

## Claims

1. Voltage-controlled current source (SQ) for a PIN diode attenuator (DG), **characterised in that** one or more resistors (R6, R7) are connected in series with an output resistor (R5) of the current source (SQ) and that a diode (D1, D2) is connected in parallel with each of these additional series-connected resistors (R6, R7).

2. Current source according to Claim 1, **characterised in that** the resistor(s) (R6, R7) connected in series with the output resistor (R5) of the current source (SQ) is/are selected to be of a value such that the control current (I) assumes a non-linear shape, dependent upon an input voltage (U1) of the voltage-controlled current supply (SQ), such that a non-linearity of the characteristic of the attenuator (DG) is thereby compensated for.

3. Current source according to Claim 1, **characterised in that** for each parallel-connected diode (D1, D2), a resistor (R8, R9) is connected in series with it.

## Revendications

1. Source de courant (SQ) commandée en tension pour un atténuateur (DG) à diodes PIN, **caractérisée en ce qu'**avec une résistance de sortie (R5) de la source de courant (SQ) sont montées en série une ou plusieurs résistances (R6, R7) et **en ce qu'**une diode (D1, D2) est montée en parallèle sur chacune de ces résistances supplémentaires (R6, R7) montées en série.

2. Source de courant selon la revendication 1, **caractérisée en ce que** la ou les résistances (R6, R7) montées en série avec la résistance de sortie (R5) de la source de courant (SQ) sont dimensionnées de façon telle qu'en fonction d'une tension d'entrée (U1) de la source de courant (Sq) commandée en tension, le courant de commande (I) adopte un tracé non linéaire tel que de ce fait une non linéarité de la ligne caractéristique de l'atténuateur (DG) soit compensée.

3. Source de courant selon la revendication 1, **caractérisée en ce qu'**une résistance (R8, R9) est montée en série avec chaque diode (D1, D2) montée en parallèle.
